# DEMANDE DE BREVET EUROPEEN

(11) **EP 2 050 842 A1**
(43) Date de publication de la demande: **22.04.2009**
(21) Numéro de dépôt: 08290976.3
(22) Date de dépôt: 17.10.2008
(51) Int. Cl.: C30B 23/02, C30B 29/26, H01F 10/20

(54) **Procede de production de films ultra-minces de ferrites**

(30) Priorité: 18.10.2007 FR 0707294
(71) Demandeur: COMMISSARIAT A L'ENERGIE ATOMIQUE, 75015 Paris (FR)
(72) Inventeur: Ramos, Ana, 75004 Paris (FR); Moussy, Jean-Baptiste, 75005 Paris (FR); Guittet, Marie-Joseph, 91190 Saint-Aubin (FR); Gaitoer-Soyer, Martine, 78960 Voising le Bretonneux (FR)
(74) Mandataire: Corizzi, Valérie

(57) **Abrégé**

Procédé de fabrication permettant la croissance par épitaxie par jets moléculaires (MBE) assistée par plasma d'oxygène atomique de couches ultra-minces de ferrites de structure spinelle.

## Description

L'invention a pour objet un procédé de fabrication permettant la croissance par épitaxie par jets moléculaires (MBE) assistée par plasma d'oxygène atomique de couches ultra-minces de ferrites de structure spinelle et en particulier de ferrites de cobalt : CoFe₂O₄ de haute qualité structurale et physique.

Elle a également pour objet certains articles susceptibles d'être obtenus par ce procédé.

Pour de nombreuses applications, dans le domaine de la chimie, de l'électronique ou dans des dispositifs magnétiques, il est nécessaire de savoir déposer sur un substrat des films d'oxydes de structure spinelle et de très haute qualité.

Pour les films d'oxydes à un seul composant métallique tels que Fe₃O₄, on utilise le plus souvent les techniques de dépôt physique en phase vapeur comme le dépôt par ablation laser pulsé (PLD) ou par épitaxie par jets moléculaires (MBE pour Molecular Beam Epitaxy) et il est possible d'obtenir des films minces de haute qualité en mettant en oeuvre l'une de ces méthodes de dépôt.

En ce qui concerne les films minces de ferrite ayant plus d'un constituant métallique tels que par exemple les oxydes binaires : CoFe₂O₄, NiFe₂O₄ ou les oxydes ternaires comme par exemple (Mn,Zn)Fe₂O₄, ces méthodes ne permettent pas d'obtenir des films minces de haute qualité de structure spinelle.

Les premières études sur les ferrites portent sur les couches minces de CoFe₂O₄ obtenues par ablation laser pulsé (Y. Suzuki et al., Appl. Phys. Lett. 68 (5), 714 (1996) ; G. Hu et al., Phys. Rev. B 62, R779 (2000); M. G. Chapeline and S. X. Wang. J. Appl. Phys. 97, 10C915 (2005); M. G. Chapeline and S. X. Wang, Phys. Rev. B 74, 014418 (2006)) ou par épitaxie par jets moléculaires (S. A. Chambers et al., J. Magn. Magn. Mater. 246, 124 (2002); L. Horng et al., J. Magn. Magn. Mater. 270, 389 (2004)). Les films réalisés selon l'orientation cristallographique (001) ou (110) sur différents substrats (MgO(001), SrTiO₃(110) et SrTiO₃(100), MgAl₂O₄(110) et MgAl₂O₄(100)) ou sur une couche tampon de CoCr₂O₄ (Y. Suzuki et al., Appl. Phys. Lett. 68 (5), 714 (1996); G. Hu et al., Phys. Rev. B 62, R779 (2000)) présentent néanmoins un désordre d'occupation des sites cationiques (présence de cations Co²⁺sur les sites tétraédriques) affectant les propriétés magnétiques des films minces et nécessitant un traitement thermique après dépôt (recuit).

Pour réaliser des couches minces de ferrite de haute qualité cristalline, on s'efforce généralement de choisir une maille du substrat qui est la plus proche possible de la maille du matériau à épitaxier afin d'éviter la nécessité de recourir à une couche tampon comme enseigné par Suzuki et al. (Y. Suzuki et al., Appl. Phys. Lett. 68 (5), 714 (1996) et brevet EP 0732428 B1). Le choix du substrat de MgO dont le désaccord de paramètre de maille avec CoFe₂O₄ est très faible (-0.38 %) est souvent retenu.

En particulier, les films de CoFe₂O₄ réalisés par Chambers *et al.* (S. A. Chambers *et al.,* J. Magn. Magn. Mater. **246**, 124 (2002)) sur des substrats de MgO(100) semblent présenter un très faible désordre cationique et leurs propriétés magnétiques sont plus proches de celles des monocristaux (brevet US 7001459 B2). Néanmoins ces propriétés ne sont établies que pour des films très épais (100 nm) réalisés avec une vitesse de dépôt de l'ordre de 72 Å/min et une température de croissance qui n'est pas très élevée (inférieure à 350 °C) afin d'éviter une diffusion des ions magnésium dans les couches, diffusion qui affecterait les propriétés magnétiques.

D'autre part il est connu que les propriétés magnétiques des systèmes de basse dimensionnalité (nanoparticules, films minces, ...) sont souvent différentes de celles des monocristaux. De nombreux travaux théoriques ou expérimentaux ont montré par exemple la réduction de la température d'ordre magnétique (température de Curie, température de Néel) lorsque l'épaisseur des films minces diminue (X. Y. Lang et al., Phys. Rev. B 73, 224444 (2006)). Cette dégradation des propriétés magnétiques dans les films est liée à la diminution des interactions entre spins à la surface par rapport à celles qui existent en volume.

Il subsiste donc le besoin d'une méthode permettant de maîtriser le procédé MBE avec suffisamment de précision et de reproductibilité pour obtenir des couches ultra-minces, c'est-à-dire par exemple des couches de 2 à 10 nanomètres d'épaisseur, dont les propriétés physiques (magnétiques, électriques, etc) sont similaires aux propriétés intrinsèques du matériau. En effet, la réalisation de couches ultra-minces aux propriétés physiques maîtrisées, présente un grand intérêt notamment dans le domaine de l'électronique de spin où l'on est amené à intégrer ces couches dans des hétérostructures complexes (jonctions tunnel magnétiques, filtres à spin, ...). En raison de leur très haute température de Curie les ferrites, et notamment la ferrite de cobalt, présentent un intérêt tout particulier.

L'invention a pour objet un procédé de fabrication d'une couche ultra-mince de ferrite par épitaxie par jets moléculaires (MBE) assistée par plasma d'oxygène atomique, et en particulier de ferrite de cobalt ayant un comportement ferrimagnétique et isolant à température ambiante.

Plus précisément, l'invention a pour objet un procédé de dépôt de couches ultra-minces de ferrites binaires AFe₂O₄ ou de ferrites ternaires ABFe₂O₄ par épitaxie par jets moléculaires (MBE) assistée par plasma d'oxygène atomique où A représente tout élément chimique apte à être combiné à Fe et O pour réaliser une ferrite et B un élément chimique différent de A et appartenant au même groupe que A. Généralement A est choisi parmi le groupe constitué des métaux, des semi-conducteurs et des terres rares.

Parmi les métaux, on choisit préférentiellement A et B dans le groupe constitué de : Co, Ni, Mn, Zn, Mg, Ca, Li, Ti, Cr, Cu.

Les semi-conducteurs sont des composés dont les propriétés de conductibilité électrique sont intermédiaires entre celle des métaux et celle des isolants. On peut citer dans cette catégorie : B, Si, Ge, As, Sb, Pe, To. Parmi les atomes semi-conducteurs utilisables dans l'invention on peut citer : Ge.

L'expression « terre rare » désigne un ensemble de 17 éléments, comprenant les lanthanides : Lanthane (La), Cerium (Ce), Praséodyme (Pr), Néodyme (Nd), Prométhium (Pm), Samarium (Sm), Europium (Eu), Gadolinium (Gd), Terbium (Tb), Dysprosium (Dy), Holmium (Ho), Erbium (Er), Thulium (Tm), Ytterbium (Yb), Lutétium (Lu), ainsi que l'Yttrium (Y) et le Scandium (Sc).

Parmi les terres rares utilisables dans l'invention on peut citer : Yb, Nd.

Ce procédé comporte les étapes suivantes :
(i) on choisit un substrat parmi les matériaux monocristallins qui conservent leur structure cristalline jusqu'à une température supérieure ou égale à 350 °C;
(ii) le substrat est placé dans une chambre de croissance ;
(iii) la pression dans la chambre de croissance est ajustée à une valeur permettant la croissance par épitaxie par jets moléculaires ;
(iv) le substrat est chauffé à une température supérieure ou égale à 350 °C;
(v) le substrat est soumis de façon simultanée :
   - à un flux d'oxygène atomique,
   - à un flux d'atomes de fer,
   - à un flux d'au moins un autre atome (A pour une ferrite binaire, A et B pour une ferrite ternaire tels que définis ci-dessus),
   les flux étant contrôlés de façon à respecter la stoechiométrie du dépôt voulu (AFe₂O₄ ou ABFe₂O₄), la somme des flux des atomes Fe, A et éventuellement B étant comprise entre 0,5 et 6 Å/min ;
(vi) la fourniture d'oxygène atomique et d'atomes Fe, A et éventuellement B étant arrêtée lorsque l'on atteint un dépôt de l'épaisseur voulue.

De façon plus détaillée, le procédé de l'invention a pour objet la production d'un dépôt d'une ferrite binaire ou ternaire sur un substrat, ce dépôt étant d'une épaisseur inférieure ou égale à 20 nm, de préférence inférieure ou égale à 15 nm, encore plus avantageusement inférieure ou égale à 10 nm et de préférence comprise entre 2 et 5 nm. Un dépôt de cette nature et d'aussi faible épaisseur n'était pas envisageable par les procédés de l'art antérieur.

Les substrats utilisables pour la mise en oeuvre du procédé de l'invention sont choisis parmi les matériaux monocristallins qui conservent leur structure à une température supérieure ou égale à 350 °C. Parmi les matériaux satisfaisant à cette double condition on peut citer l'alumine en phase alpha : α-Al₂O₃.

Avantageusement, le matériau utilisé comme substrat dans le procédé de l'invention a été coupé, préalablement à sa mise en oeuvre, selon une direction de la maille dans le plan (0001) permettant ainsi une croissance selon l'orientation (111). De préférence, il présente une désorientation du plan cristallin très faible (inférieure à 5 degrés) et une surface, destinée à être soumise aux flux d'oxygène atomique et d'atomes de fer, A et éventuellement B, sensiblement plane (rugosité inférieure à un nanomètre).

Pour maîtriser la production de films ultra-minces de ferrite, il importe d'utiliser un flux d'oxygène atomique ayant un taux de dissociation sensiblement constant tout au long du processus, c'est-à-dire un taux de dissociation présentant au cours du procédé une variation inférieure à 20% par rapport à la valeur initialement choisie.

Avantageusement, on utilise un flux d'oxygène atomique dont le taux de dissociation [O]/[O₂] est au moins égal à 5 % et encore plus avantageusement supérieur ou égal à 10 %.

Le choix d'un substrat monocristallin dont la structure reste stable à une température supérieure à 350 °C présente l'avantage de permettre de chauffer le substrat à une température élevée et de le soumettre aux flux d'oxygène atomique et des atomes Fe, A et éventuellement B à une température également élevée sans que sa structure ne se trouve désorganisée.

Dans l'art antérieur, MgO(001) étant employé comme substrat, on a constaté que le chauffage du substrat à une température supérieure à 350 °C entraînait une dégradation de la structure cristalline du dépôt et la diffusion d'atomes de magnésium dans le dépôt.

De façon avantageuse, le substrat est choisi pour présenter un désaccord de paramètre de maille avec le dépôt de ferrite compris :
- soit entre 0 et 0,5 % en valeur absolue,
- soit entre 2 et 10 % en valeur absolue.

Dans le premier cas, le désaccord de paramètre de maille est quasi nul et le dépôt se fait en adoptant la même structure cristalline que celle du substrat.

Dans le second cas, le désaccord de paramètre de maille est suffisamment grand pour que le dépôt soit relaxé et ne soit pas contrôlé par la structure cristalline du substrat.

Par exemple, la croissance peut être obtenue selon l'orientation (111) sur un substrat de α-Al₂O₃(0001) ou sur une sous-couche métallique apte à être épitaxiée sur ce substrat et présentant une faible rugosité de surface (par exemple une couche de platine orientée (111)). Malgré le fort désaccord de paramètre de maille entre le substrat et la ferrite considérée (de l'ordre de 8 %) ou entre la sous-couche conductrice utilisée et la ferrite (de l'ordre de 7 % pour le platine), ce choix permet de travailler à une température de croissance supérieure à 350 °C, ce qui favorise une meilleure diffusion des espèces en surface et améliore la qualité cristalline des couches, point très important pour la réalisation de films ultra-minces.

De façon avantageuse, avant d'être introduit dans la chambre de croissance, le substrat est soumis à un nettoyage chimique, de préférence par une solution oxydante.

De façon avantageuse également, le substrat est soumis à un traitement par un plasma d'oxygène atomique après son introduction dans la chambre de croissance et avant le traitement de l'étape (v).

Le nettoyage chimique et le traitement par un flux d'oxygène atomique permettent d'enlever la couche de pollution présente à la surface du substrat. Avantageusement, cette étape est contrôlée par spectroscopie d'électrons Auger (AES).

A l'étape (iii) la pression dans la chambre de croissance est ajustée à une valeur permettant la mise en oeuvre des traitements ultérieurs. De façon connue, la pression est ajustée à une valeur comprise entre 10⁻¹¹ et 10⁻¹² bar.

La température du porte-échantillon de la chambre de croissance est ajustée à une valeur supérieure ou égale à 350 °C, avantageusement à une valeur comprise entre 400 °C et 1000 °C, encore plus préférentiellement entre 450 °C et 600 °C. La température est avantageusement contrôlée à l'aide d'un thermocouple et/ou par pyrométrie optique.

Le choix d'une température élevée pour l'étape de croissance de la couche de ferrite permet de réaliser cette croissance à une faible vitesse de dépôt tout en permettant une bonne diffusion des espèces en surface. Ainsi il est possible d'obtenir des couches ultra-minces dotées d'une qualité cristalline satisfaisante.

Avantageusement, les caches, disposés devant les creusets, sont ouverts pendant au moins 15 minutes avant le début de la croissance (le porte-échantillon étant relevé pour ne pas être dans les flux) afin de s'affranchir des variations de flux au début de la croissance. Ensuite, le porte-échantillon est basculé dans les flux de fer et des éléments A et éventuellement B et soumis simultanément au plasma d'oxygène atomique.

Les vitesses de dépôt des éléments considérés (disposés dans des cellules à effusion de Knudsen ou dans des cellules à bombardement électronique) sont contrôlées à l'aide d'une micro-balance à quartz positionnée à proximité du porte-échantillon afin d'obtenir la bonne stoechiométrie. Les flux des atomes choisis correspondent à un flux total compris entre 0,5 Å/min et 6 Å/min, avantageusement entre 0,8 Å/min et 2 Å/min. Ces vitesses de dépôt sont lentes afin d'assurer une bonne diffusion des espèces en présence sur la surface dès la croissance des premiers plans atomiques d'oxydes.

De façon avantageuse, le porte-échantillon est en rotation durant la croissance afin de réaliser un dépôt d'épaisseur homogène.

Les conditions d'oxydation (puissance plasma, pression d'oxygène) sont importantes pour contrôler le mode de croissance (bidimensionnel versus tridimensionnel) et la stoechiométrie de la ferrite réalisée. La procédure consiste à faire varier progressivement la pression d'oxygène (p) pendant les 15 premières minutes de dépôt afin d'une part d'initier un mode de croissance bidimensionnel (2D) du film et d'autre part d'obtenir la bonne stoechiométrie. Une fois la croissance 2D initiée (entre 0 et 5 min), la pression (p) est modifiée progressivement (entre 5 et 15 min) pour obtenir la bonne phase. La puissance (P) du plasma d'oxygène atomique est comprise entre 200 W et 500 W, avantageusement entre 300 W et 400 W, et la pression p varie entre 1,33 10⁻⁴ bar (0,10 Torr) et 6,66 10⁻⁴ bar (0,50 Torr) pendant les 15 premières minutes selon la ferrite considérée.

Avantageusement, la croissance des films est suivie en temps réel par diffraction d'électrons de haute énergie (tension d'accélération : 30 kV) en incidence rasante (angle d'incidence de quelques degrés) ou diffraction RHEED. L'analyse des clichés de diffraction permet de s'assurer du mode de croissance bidimensionnel et de la bonne structure cristallographique des films tout au long de la croissance. Les clichés RHEED sont enregistrés selon des orientations cristallographiques appropriées afin de vérifier la qualité structurale du dépôt et la présence de la structure spinelle caractéristique de la ferrite synthétisée.

Comparativement aux procédés de l'art antérieur, le procédé de l'invention permet de former un dépôt ultra-mince d'une couche de ferrite de structure spinelle sur un substrat avec une qualité cristalline de ce dépôt très élevée. Ce procédé permet d'obtenir selon le choix des éléments A et éventuellement B des articles utilisables comme filtres à spin ou comme jonctions tunnel magnétiques.

Un autre objet de l'invention est un article comprenant :
(a) une première couche d'un matériau choisi parmi les matériaux monocristallins qui conservent leur structure à une température supérieure ou égale à 350 °C,
(b) une seconde couche d'une ferrite binaire (AFe₂O₄) ou ternaire (ABFe₂O₄) avec A et B définis précédemment. Cette seconde couche étant d'une épaisseur inférieure ou égale à 20 nm, de préférence inférieure ou égale à 15 nm, encore plus avantageusement inférieure ou égale à 10 nm et de préférence comprise entre 2 et 5 nm,
   étant entendu qu'est exclu le cas où :
   - la première couche est α-Al₂O₃,
   - la seconde couche est CoFe₂O₄.

Avantageusement, la seconde couche est déposée directement sur la première, sans couche intermédiaire.

Selon une variante, l'article de l'invention comporte une couche métallique intermédiaire épitaxiée et de faible rugosité permettant la croissance de la ferrite considérée.

De façon avantageuse, la première couche est constituée de α-Al₂O₃ et la seconde couche est choisie parmi les ferrites binaires NiFe₂O₄ ou ternaires (Mn,Zn)Fe₂O₄.

Le procédé selon l'invention permet de réaliser des couches ultra-minces de ferrites comme par exemple CoFe₂O₄, ces couches ayant une rugosité de surface inférieure à 5 nm, de préférence inférieure à 3 nm et de manière encore plus préférée de l'ordre de 1 nm grâce à une température supérieure ou égale à 400 °C, et une vitesse de dépôt inférieure ou égale à 6 Å/min. Cette très faible rugosité associée à des interfaces abruptes permet la réalisation de jonctions tunnel magnétiques ou magnétorésistives (JTM) ou de filtres de spin.

De tels articles sont susceptibles d'être obtenus par le procédé décrit ci-dessus.

### PARTIE EXPERIMENTALE

### Matériel utilisé :

- Chambre de croissance (MBE) :
   Meca 2000, enceinte d'évaporation : 350.
   37, Rue S^{t}-Léger 78540 Vernouillet - France
- Source d'oxygène atomique :
   Source radio-fréquence d'oxygène atomique
   Société Addon, 33 rue Casimir Perier - 95870 Bezons - France.
- Creusets :
   Cellules à effusion de Knudsen, Meca 2000
   37, Rue S^{t}-Léger 78540 Vernouillet - France
- Source de métaux :
   Fe, Co: pureté 99.99 %
   Alfa-Aesar Johnson Matthey Company, Zeppelinstr.7 D-76185 Karlsruhe.
- Spectromètre d'électrons Auger (AES) :
   Physical Electronics, model 32-150
   18725 Lake Drive East Chanhassen, MN 55317
- Canon à électrons (RHEED) :
   Staib instruments GmbH, Hagenaustrasse 22, 85416 Langenbach - Allemagne.
- Spectromètre de photoémission X (XPS) :
   Source X Riber : modèle CX700 et analyseur Thermo ClamII
   Riber, 31 rue Casimir Perier - 95873 Bezons - France.
- Diffractomètre X (θ/2θ) et réflectomètre X
   Bruker AXS : www.bruker-axs.com/
- Microscope électronique à transmission (TEM) :
   JEOL 4000EX (Cs=1mm -résolution ponctuelle de 0.17 nm)
- Magnétomètre à échantillon vibrant (VSM) : modèle ADE-4HF
   ADE Magnetics, 80 Wilson Way Westwood, Massachusetts 02090 USA
- Appareil de magnéto-transport (PPMS) : modèle PPMS + P600 (7 teslas longitudinal). Quantum Design, 6325 Lusk Boulevard, San Diego, CA 92121-3733 USA.
- Les substrats α-Al₂O₃(0001) sont fournis par la société RSA Le Rubis (RSA Le Rubis, B.P. 16 38560 Jarrie). Ces substrats présentent les spécifications suivantes : dimension : 12 × 8 mm (tolérance : ± 0,5 mm). épaisseur : 0,3 mm (tolérance : ± 0,05 mm). orientation : axe [0001] perpendiculaire aux faces (tolérance : ± 5°).

### FIGURES :

**FIGURE 1** : De haut en bas et de gauche à droite : clichés de diffraction RHEED du substrat de α-Al₂O₃(0001) et d'une couche simple de CoFe₂O₄(111) (3 nm) à différents stades de la croissance selon les deux directions cristallographiques [1 -1 0 0] et [1 0 -1 0]. Les flèches indiquent l'apparition des tiges de diffraction caractéristiques de la phase spinelle.
**FIGURE 2** : Spectre d'électrons Auger (AES) permettant de s'assurer de la stoechiométrie et de la bonne continuité d'une couche ultra-mince de CoFe₂O₄ (4 nm).
**FIGURE 3** : Spectres de photoémission X (XPS) aux seuils 2p du fer et du cobalt sur une couche ultra-mince de CoFe₂O₄ montrant le bon degré d'oxydation du fer (Fe³⁺) et du cobalt (Co²⁺) et permettant de s'assurer de la stoechiométrie des films minces de CoFe₂O₄.
**FIGURE 4** : Spectre de diffraction X (θ/2θ) et courbe de réflectivité X d'une couche simple de CoFe₂O₄ (15 nm). La courbe de réflectivité est parfaitement modélisée par les paramètres de la ferrite de cobalt et montre la faible rugosité de surface de cette couche mince.
**FIGURE 5** : Image de microscopie électronique en transmission selon l'axe de zone [1 1 -2] montrant la parfaite épitaxie de CoFe₂O₄ (5 nm).
**FIGURE 6** : Cycle d'hystérésis à 300 K d'une couche simple de CoFe₂O₄ (3 nm) prouvant le comportement ferromagnétique de cette ferrite en couche ultra-mince.
**FIGURE 7**: Mesure de transport électrique d'une couche simple de CoFe₂O₄ (15 nm) prouvant le comportement isolant de cette ferrite.

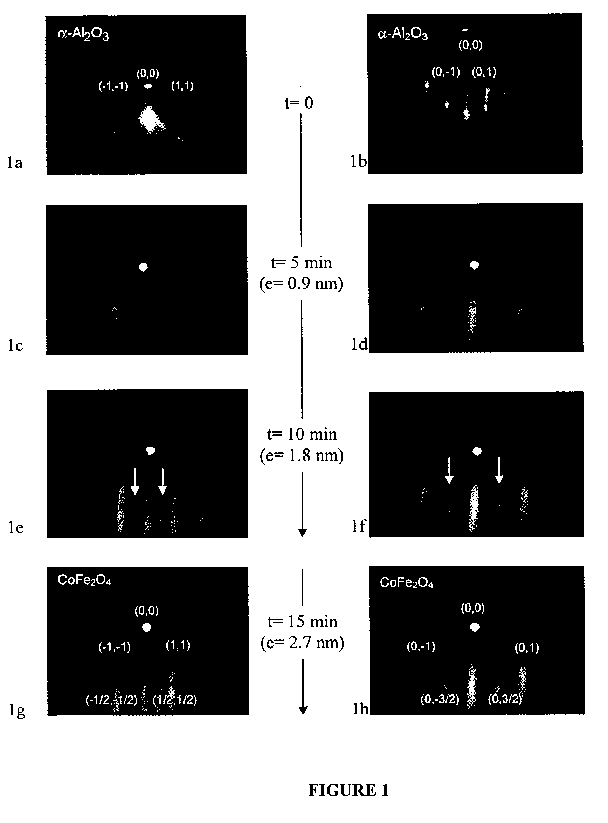

1) Préparation chimique du substrat :
   - Avant toute chose, le substrat de α-Al₂O₃(0001) est nettoyé chimiquement dans une solution constituée de 1 ml de NH₄OH, 1ml de H₂O₂, 100 ml d'eau distillée pendant 2 minutes puis rincé à l'eau distillée et séché sous un flux d'azote gazeux.
   - Une fois introduit dans le bâti de MBE, le substrat est chauffé à une température supérieure à 350 °C pour être soumis à un plasma d'oxygène atomique. La source à oxygène utilisée est une source radio-fréquence à plasma d'oxygène monoatomique de puissance (P) constituée d'une cavité en quartz (pression d'oxygène dans la cavité : p) ayant un fort pouvoir oxydant : [O]/[O₂] au moins égal à 10 %.
   - Une fois introduit dans le bâti de MBE, l'échantillon est chauffé à une température de 450 °C pour être soumis à un plasma d'oxygène atomique. Le substrat est exposé pendant 5 minutes au plasma d'oxygène suivant : P= 325 W, p= 1,73 10⁻⁴ bar (0,13 Torr), afin d'enlever la couche de pollution (carbone) présente à la surface du substrat. Cette étape est contrôlée *in situ* par spectroscopie d'électrons Auger (AES).
2) Vitesses de dépôt des éléments :
   Les cellules à effusion de Knudsen comportant les éléments métalliques : fer et cobalt (pureté de chaque élément : 99,99 %) sont chauffées aux températures d'évaporation voulues. Les vitesses de dépôt choisies (contrôlées à l'aide de la micro-balance à quartz) sont 0,3 Å/min pour le Co et 0,6 Å/min pour le Fe correspondant à un flux métallique total de 0,9 Å/min. La vitesse de dépôt d'un plan d'oxyde sous ces conditions est donc de 1,8 Å/min.
   Les caches, disposés devant les cellules de Fe et de Co, sont ouverts pendant 15 min avant le début de la croissance (le porte-échantillon étant relevé pour ne pas être dans les flux de Fe et Co) afin de s'affranchir des variations de flux qui pourraient être présentes au tout début de la croissance et qui pourraient altérer la qualité des couches ultra-minces.
3) Température de croissance :
   La croissance est réalisée à la température de 450 °C (mesurée avec un thermocouple Chromel-Alumel). Le porte-échantillon est en rotation durant la croissance afin d'éviter des gradients d'épaisseur dans les couches.
4) Conditions d'oxydation :
   La pression d'oxygène (p) est augmentée progressivement pendant les 15 premières minutes de dépôt dans le but d'assurer un mode de croissance bidimensionnel (2D) du film. Tout d'abord la pression (p) est de 2,66 10⁻⁴ bar (0,2 Torr) puis elle est augmentée progressivement pour atteindre 2,9 10⁻⁴ bar (0.22 Torr) à 5 min, puis à 0,24 Torr à 10 min et enfin à 3,2 10⁻⁴ bar (0,26 Torr) au bout de 15 min.
5) Analyse *in situ* par diffraction RHEED :
   Les clichés RHEED (figures 1a-1h) ont été obtenus selon deux orientations cristallographiques appropriées (indexées [1 0 -1 0] et [1 -1 0 0] dans le réseau hexagonal du substrat de saphir). Les deux premiers clichés RHEED montrent la parfaite qualité cristalline du substrat de saphir. Ensuite 1a croissance de la ferrite de cobalt débute. On observe à partir de 5 minutes (soit une épaisseur de 0,9 nm) selon les deux directions cristallographiques l'apparition de tiges de diffraction supplémentaires. Ces tiges, qui se renforcent au cours du temps (t= 10 min, 15 min), sont caractéristiques de la structure spinelle de CoFe₂O₄.

### Caractérisations structurales et chimiques

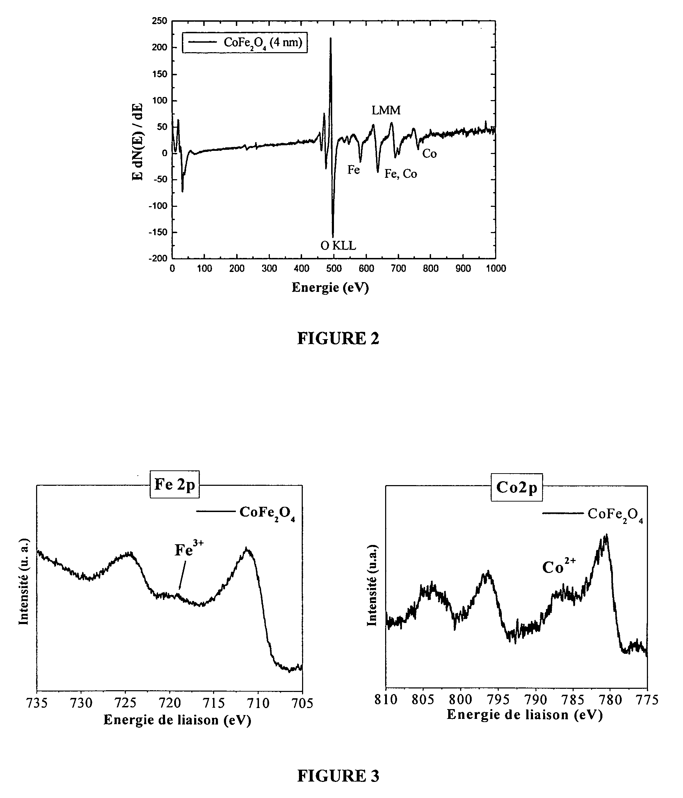

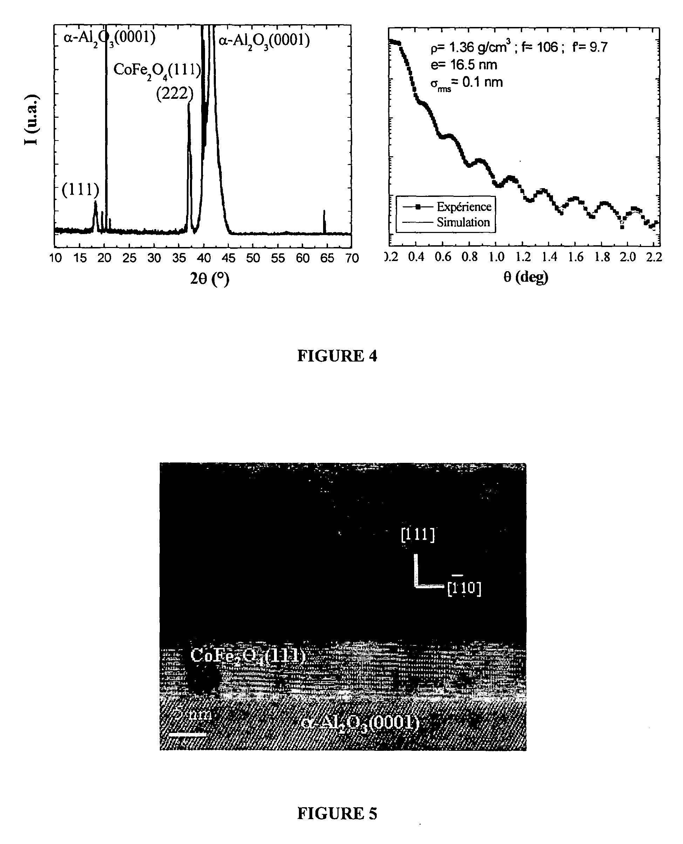

Une fois la croissance épitaxiale des films de CoFe₂O₄(111) terminée, nous avons étudié les propriétés chimiques et structurales des films réalisés.
1) Spectrométrie d'électrons Auger (AES) :
   Des mesures *in situ* réalisées par spectroscopie d'électrons Auger ont permis de vérifier la stoechiométrie et la continuité des couches ultra-minces de CoFe₂O₄ après dépôt (figure 2).
2) Spectrométrie de photoémission X (XPS) :
   Des mesures *in situ* réalisées par spectrométrie de photoémission X (XPS) ont permis de contrôler l'état d'oxydation du fer et du cobalt et la stoechiométrie des couches après dépôt (figure 3). Ces mesures ont été effectuées avec la raie K_{α} du magnésium afin de s'affranchir de la présence de pics Auger dans le domaine d'énergie des raies Co 2p.
   Le rapport Co/Fe a également été contrôlé (exact dans la limite de 10 % compte tenu de la précision de la méthode).
3) Diffraction et réflectivité X
   Les mesures de diffraction X ont permis d'une part de contrôler la structure cristalline en volume des couches CoFe₂O₄ et d'autre part de vérifier l'absence de phases parasites dans les films. Les mesures de réflectivité X ont été effectuées, quant à elles, afin de mesurer l'épaisseur et la rugosité de surface (σᵣₘₛ) des couches, rugosité qui est très faible, point crucial pour la réalisation par exemple de jonctions tunnel magnétiques aux interfaces abruptes. Avec une température de 450°C et une vitesse de dépôt de 1,8 Å/min, la rugosité de surface des couches est de l'ordre de 1 nm, ce qui permet la réalisation de jonction tunnel magnétique et de filtre de spin.
4) Microscopie électronique en transmission (MEHR)
   Une étude par microscopie électronique en transmission (MEHR) (Coll. DRFMC-CEA, Grenoble) a permis de s'assurer de la qualité structurale des couches minces de CoFe₂O₄ (figure 5).
   Les images obtenues en haute résolution montrent le parfait empilement des plans cationiques de fer et de cobalt parallèlement à la surface du substrat.
   Ces analyses ont également démontré l'absence de phases parasites aux interfaces et la faible rugosité de surface des couches.
5) Dichroïsme magnétique circulaire (XMCD)
   CoFe₂O₄ cristallise dans une structure spinelle inverse, c'est-à-dire que les 8 sites tétraédriques (A) de la maille conventionnelle cubique à faces centrées des ions oxygènes doivent contenir les cations Fe³⁺ tandis que les 16 sites octaédriques (B) doivent être occupés en quantité égale par les cations Co²⁺ et les cations Fe³⁺. Cependant il a été observé dans l'art antérieur que l'existence d'un désordre d'occupation de ces sites (Co²⁺ en site tétraédrique par exemple) ou la présence de cations avec d'autres degrés d'oxydation (Co³⁺, Fe²⁺) affectait notablement les propriétés magnétiques et/ou électroniques de cette ferrite. C'est pourquoi nous avons effectué des expériences de dichroïsme magnétique circulaire (XMCD) afin d'analyser l'état d'oxydation des cations et l'ordre d'occupation des sites A et B. Les mesures XMCD, effectuées aux seuils K et L₂,₃ du Co et du Fe, ont permis d'une part de vérifier l'existence uniquement de la valence 2+ pour le cobalt et 3+ pour le fer et d'autre part de mettre en évidence la présence d'une structure spinelle inverse avec un très faible taux d'inversion d'occupation des sites A et B (taux inférieur à 10 %).

### Réalisation d'un objet unique par ce procédé de fabrication

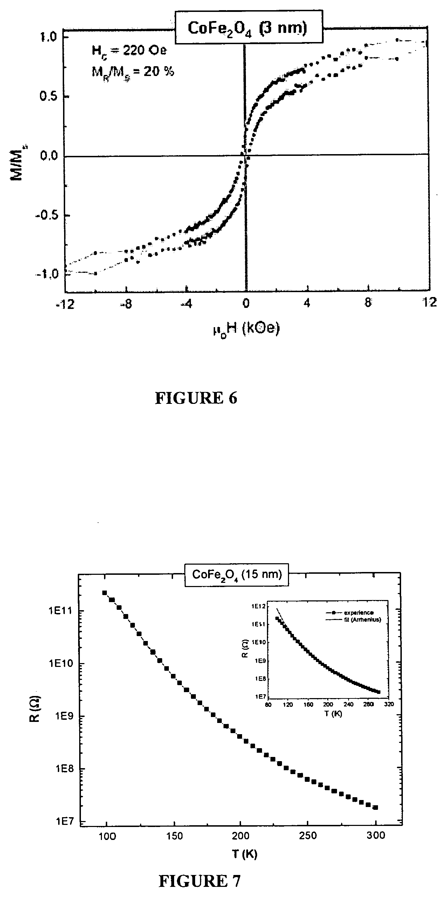

Grâce au procédé de fabrication décrit précédemment, nous avons été en mesure de réaliser des couches ultra-minces de CoFe₂O₄ de quelques nanomètres d'épaisseur, qui ont été caractérisées magnétiquement (cycles d'hystérésis par magnétométrie VSM et SQUID) entre 4 K et 300 K et entre plus ou moins 6 teslas. Ces mesures ont mis en évidence la présence d'un comportement ferrimagnétique avec un moment magnétique de 2,7 µ_{B}, un champ coercitif de l'ordre de 200 Oe et une rémanence de 20 % (figure 6). La rémanence et le champ coercitif obtenus sont plus petits que dans des couches épaisses (H_{c}= 2000 Oe, rémanence de 30 % dans une couche de 15 nm). Néanmoins la présence d'un faible champ coercitif devrait faciliter l'intégration de ces barrières magnétiques dans des dispositifs fonctionnels.

Ces mesures magnétiques démontrent donc pour la première fois le caractère ferrimagnétique des couches ultra-minces de CoFe₂O₄(111) et montrent les avantages de la méthode de croissance présentée ici pour la réalisation de couches magnétiques ultra-minces.

Les mesures de transport électrique réalisées sur les couches minces ont également montré le caractère isolant des films à température ambiante. La figure 7 présente la dépendance en température sur une couche épaisse de 15 nm.

Les films ultra-minces présentent des résistivités équivalentes (p=140 Ω.cm à température ambiante), ce qui valide leur utilisation par exemple comme barrière tunnel magnétique à température ambiante dans des dispositifs de type filtre à spin.

## Revendications

1. Procédé de fabrication d'une couche mince de ferrite binaire AFe₂O₄ ou ternaire ABFe₂O₄ par épitaxie par jets moléculaires (MBE) assistée par plasma d'oxygène atomique où A et B distincts représentent tout élément chimique apte à être combiné à Fe et O pour réaliser une ferrite,
ce procédé comportant les étapes suivantes :
(i) on choisit un substrat parmi les matériaux monocristallins qui conservent leur structure cristalline jusqu'à une température supérieure ou égale à 350 °C;
(ii) le substrat est placé dans une chambre de croissance ;
(iii) la pression dans la chambre de croissance est ajustée à une valeur permettant la croissance par épitaxie par jets moléculaires ;
(iv) le substrat est chauffé à une température supérieure ou égale à 350 °C;
(v) le substrat est soumis de façon simultanée :
- à un flux d'oxygène atomique,
- à un flux d'atomes de fer,
- à un flux d'au moins un autre atome (A pour une ferrite binaire, A et B pour une ferrite ternaire),
les flux étant contrôlés de façon à respecter la stoechiométrie du dépôt voulu (AFe₂O₄ ou ABFe₂O₄), la somme des flux des atomes (Fe, A et éventuellement B) étant comprise entre 0,5 et 6 Å/min ;
(vi) la fourniture d'oxygène atomique et d'atomes (Fe, A et éventuellement B) étant arrêtée lorsque l'on atteint un dépôt de l'épaisseur voulue, ce procédé étant **caractérisé en ce que** la pression (p) d'oxygène varie progressivement pendant les 15 premières minutes de dépôt entre 1,33.10⁻⁴ et 6,66.10⁻⁴ bar.

2. Procédé selon la revendication 1, dans lequel A et éventuellement B sont choisis parmi le groupe constitué des métaux, des semi-conducteurs et des terres rares.

3. Procédé selon la revendication 2, dans lequel A et éventuellement B sont choisis parmi le groupe constitué de : Co, Ni, Mn, Zn, Mg, Ca, Li, Ti, Cr, Cu, Ge, Yb, Nd.

4. Procédé selon l'une quelconque des revendications 1 à 3, dans lequel l'épaisseur du dépôt est inférieure ou égale à 20 nm, de préférence inférieure ou égale à 15 nm.

5. Procédé selon la revendication 4, dans lequel l'épaisseur du dépôt est inférieure ou égale à 10 nm, avantageusement comprise entre 2 et 5 nm.

6. Procédé selon l'une quelconque des revendications 1 à 5 dans lequel le substrat est l'alumine en phase alpha : α-Al₂O₃.

7. Procédé selon l'une quelconque des revendications précédentes, dans lequel le matériau utilisé comme substrat a été coupé, préalablement à sa mise en oeuvre, selon une direction de la maille dans le plan (0001).

8. Procédé selon l'une quelconque des revendications précédentes, dans lequel le substrat est choisi pour présenter un désaccord de paramètre de maille avec le dépôt de ferrite compris entre 0 et 0,5 %.

9. Procédé selon l'une quelconque des revendications précédentes, dans lequel le substrat est choisi pour présenter un désaccord de paramètre de maille avec le dépôt de ferrite compris entre 2 et 10 %.

10. Procédé selon l'une quelconque des revendications précédentes, dans lequel le substrat est recouvert d'une couche métallique épitaxiée.

11. Procédé selon l'une quelconque des revendications précédentes, dans lequel, avant d'être introduit dans la chambre de croissance, le substrat est soumis à un nettoyage chimique.

12. Procédé selon l'une quelconque des revendications précédentes, dans lequel le substrat est soumis à un traitement par un plasma d'oxygène atomique après son introduction dans la chambre de croissance et avant le traitement de l'étape (v).

13. Procédé selon l'une quelconque des revendications précédentes, dans lequel à l'étape (iii) la pression dans la chambre de croissance est ajustée à une valeur comprise entre 10⁻¹¹ et 10⁻¹² bar.

14. Procédé selon l'une quelconque des revendications précédentes, dans lequel la température de la chambre de croissance est ajustée à une valeur comprise entre 400 °C et 1000 °C, encore plus préférentiellement entre 450 °C et 600 °C.

15. Procédé selon l'une quelconque des revendications précédentes, dans lequel les flux des atomes sont choisis de façon à avoir un flux total compris entre 0,8 Å/min et 2 Å/min.

16. Procédé selon l'une quelconque des revendications précédentes, dans lequel la puissance du plasma d'oxygène atomique est comprise entre 200 W et 500 W, avantageusement entre 300 W et 400 W.
